# EUROPEAN PATENT APPLICATION

(11) **EP 4 435 446 A1**
(43) Date of publication of application: **25.09.2024**
(21) Application number: 24164532.4
(22) Date of filing: 19.03.2024
(51) Int. Cl.: G01R 31/3185, G06F 30/333

(54) **SCAN WRAPPER CIRCUIT AND WRAPPER CELLS**

(30) Priority: 23.03.2023 IN 202341020322
(71) Applicant: NXP B.V., 5656 AG Eindhoven (NL)
(72) Inventor: Makkar, Shikhar, 5656AG Eindhoven (NL); Gupta, Chandan, 5656AG Eindhoven (NL)
(74) Representative: Miles, John Richard

(57) **Abstract**

An apparatus **(110)** and method **(200)** are provided for scan testing a system-on-chip (SoC) integrated circuit having first and second partitions coupled together across one or more inter-partition circuits, each of which includes a decompressor; a compactor; an INTEST scan chain and an EXTEST scan chain coupled in parallel between the decompressor circuit and compactor circuit; and digital test control access hardware connected between the decompressor circuit and each INTEST scan chain and configured to selectively disable each INTEST scan chain while each EXTEST scan chain continues to operate in response to a partition EXTEST mode signal having a first predetermined value.

## Description

### BACKGROUND

### Field

The present disclosure is directed in general to the field of testing system-on-chip (SoC) systems. In one aspect, the present disclosure relates generally to an SoC scan wrapper architecture, circuit, method and apparatus.

### Description of the Related Art

With advances in the design and manufacture technology for SoC systems and devices, increasingly complex electronic designs are embedded on a single chip. However, because of the complexity and density of such circuits, SoC systems may suffer from various manufacturing defects caused by, for example, contamination by dust particles during fabrication, overheating during fabrication, or the like. Such manufacturing defects may affect the operations of the SoC, and hence, testability of SoC systems for defects has increasing importance. However, modern integrated circuits often limit or prevent any access to certain portions which are not directly accessible from external pins and/or various other functional units. To overcome the problem of having limited access to internal circuit areas via functional units, various design-for-test (DFT) techniques have been developed. One such technique is a "scan testing" technique which provides internal scan chains in the device wherein a number of serially coupled scan elements are used to input or load test stimulus data into the integrated circuit, to conduct tests of circuitry within the integrated circuit based on the test stimulus data, to capture test result data from the scan elements, and to shift the captured data from the integrated circuit for further analysis. In a "scan mode," input test data is loaded into internal state elements (e.g., flip-flops) of the SoC that are serially chained to form scan chains that function as shift registers. During scan testing, shift and capture operations are performed, in which test patterns are shifted through the scan chains.

### BRIEF DESCRIPTION OF THE DRAWINGS

The present invention may be understood, and its numerous objects, features and advantages obtained, when the following detailed description of a preferred embodiment is considered in conjunction with the following drawings.
Figure 1 illustrates a block diagram of a multi-partition system-on-chip (SoC).
Figure 2 is a simplified schematic block diagram of an integrated circuit with a first conventional scan chain testing design for testing SoC digital logic.
Figure 3 is a simplified schematic block diagram of an integrated circuit with a second conventional partitioned scan chain testing design for testing SoC digital logic.
Figure 4 is a simplified schematic block diagram of an integrated circuit with a third conventional partitioned scan chain testing design using controllable and observable test points at each partition for testing SoC digital logic.
Figure 5 is a simplified schematic block diagram of an integrated circuit with a fourth conventional partitioned scan chain testing design using controllable and observable test points and wrapper flops at each partition for testing SoC digital logic.
Figure 6 is a simplified schematic block diagram of an integrated circuit with a fifth conventional partitioned scan chain testing design using INTEST and EXTEST chains that are separately controlled with external EXTEST decompressors and compactors for testing SoC digital logic.
Figure 7 is a simplified schematic block diagram of an integrated circuit with a scan chain testing design using INTEST and EXTEST chains that are separately controllable with internal logical AND gating and separate launch off shift scan enable signals for testing SoC digital logic in accordance with selected embodiments of the present disclosure.
Figure 8 is a schematic circuit diagram of a conventional launch off shift scan enable signal generator.
Figure 9 is a schematic circuit diagram of a launch off shift scan enable signal generator for generating separate launch off shift scan enable signals in accordance with selected embodiments of the present disclosure.
Figure 10 is a simplified schematic block diagram of an integrated circuit with a partitioned scan chain testing design using INTEST and EXTEST chains that are separately controllable with internal logical AND gating and separate launch off shift scan enable signals for testing SoC digital logic in accordance with selected embodiments of the present disclosure.
Figure 11 illustrates a simplified flow chart showing the logic for efficiently enabling scan testing of at least a portion of a multi-partition SoC in accordance with selected embodiments of the present disclosure.

### DETAILED DESCRIPTION

A scan wrapper architecture, circuit, system, apparatus, and methodology are described for efficiently enabling test mode operations on a multi-partition SoC chip by configuring each partition with separately controllable INTEST and EXTEST scan chains connected between a decompressor and compactor. To enable scan testing of inter-partition circuits connected between the EXTEST scan chain of a first preceding or upstream partition and the INTEST scan chain(s) of a second receiving or downstream partition, each partition includes digital test control access hardware for each INTEST scan chain which may be selectively disabled while allowing the EXTEST scan chain to continue operating. In operation, the digital test control access hardware may be configured to load a constant scan data input value to each INTEST scan chain during EXTEST scanning mode, thereby saving power that would otherwise be used to shift different scan data input values into each INTEST scan chain. In selected embodiments, the digital test control access hardware circuitry may be embodied with scan data input gating circuitry for logically combining (e.g., with an "AND" gate) an inverted partition EXTEST mode signal with a first decompressed scan data input signal that is input to said INTEST scan chain. In addition, each partition includes a launch-off-shift (LOS) scan enable circuit for generating separately controllable scan enable signals for the INTEST scan chain(s) (SE_INT) and EXTEST scan chain(s) (SE_EXT) in response to the partition EXTEST mode signal. With the disclosed scan wrapper approach of providing a scan data input AND gating circuit at each INTEST scan chain, comprehensive and efficient scan testing of multi-partition SoC systems is provided which does not require additional test logic overhead (in terms of test points, wrapper flops or multiple decompressor and compactor blocks), which imposes no timing degradation on the functional paths, which requires no additional netlist insertion overhead except for the AND gate on the INTEST scan chains, which does not require that scan data be shifted into scan chains at the functional frequency, and which requires minimal test logic for inter-partition coverage.

By way of contextual background information to the present disclosure, advances in the design and manufacture technology for SoC systems and devices have resulted in increasingly large or dense electronic designs being embedded on a single chip. Unfortunately, the increasing size of SoCs systems makes it almost impossible to run the scan patterns over the entire SoC at once due to pin limitations, shift frequency limitations, and/or huge power consumption during scan operations. In addition, larger SoC systems have larger test times (and associated costs), with scan tests forming a major portion of total test time. One solution for controlling test costs is to increase shift frequency used during scan testing, but there are trade-offs between shift frequency and shift power and test coverage since an entire device can be tested with a first maximum frequency, but for higher frequencies, device testing requires partitioning of the device and testing of the partitions in multiple sets. Thus, an optimal value for shift frequency and portion of device enabled for a particular duration of scan testing has to be found. Another approach for controlling test costs is to use Q-gating to reduce shift power, but this can adversely impact physical implementation since Q-gates are put in functional paths, making them timing-critical. Also, ideal candidates for Q-gating are complex combinational blocks which already have tight timing requirements. Another test power reduction solution is to split the SoC system designs into multiple partitions (i.e., cores) that are tested independently so that scan operations are targeted on a smaller logic footprint to reduce the device power consumption. A partition typically includes multiple scan chains that form the core logic of the partition and wrapper chains at input and output boundaries to isolate the partition from the remaining design. However, even with multi-partition SoC system designs, there are significant challenges with providing comprehensive scan mode tests. For example, the functional paths, such as clock paths and/or data paths, can be changed by adding scan wrapper circuits which impact functional clock and data path timing. In addition, extra scan shift paths are introduced by wrapper scan chains, adding more timing overhead. Another challenge is that functional paths cannot be tested at-speed. There are also challenges with getting scan test coverage of the "inter-partition" transition circuits located between partitions. For example, additional test logic overhead may be required for meeting coverage targets for the "inter-partition" transition circuits. In addition, there can be timing closure overhead with conventional approaches for testing "inter-partition" transition circuits, including timing degradation on functional paths due to additional test logic, as well as the introduction of new timing paths introduced due to additional test logic. Another challenge with testing multi-partition SoC systems is requirement of additional patterns being required as compared to patterns generated for single-chip test solutions. As seen from the foregoing, the existing solutions for efficiently providing comprehensive test coverage are not effective for modern integrated circuits and SoC systems. They are extremely difficult at a practical level by virtue of the difficulty to balance the design constraints for test access with the requirement to provide comprehensive scan testing coverage in light of pin limitations and power considerations.

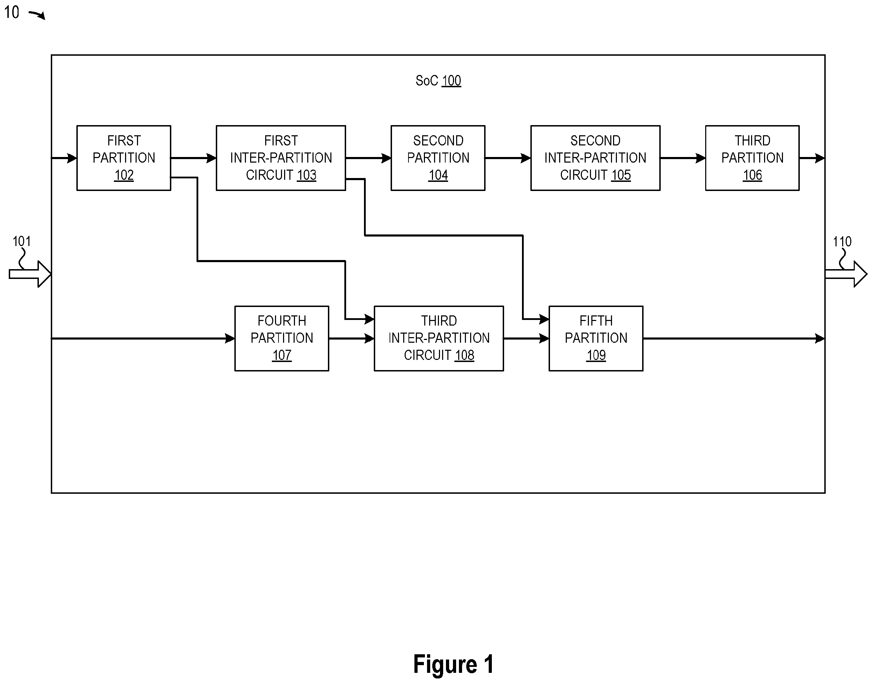

To provide a contextual understanding for selected embodiments of the present disclosure, reference is now made to Figure 1 which illustrates a block diagram 10 of a multi-partition system-on-chip (SoC) 100. The SoC 100 refers to an integrated circuit that integrates multiple components of a computer or other electronic system on a single substrate or microchip. The SoC 100 may be embedded within an electronic system (not shown) such as an automotive system, an aircraft guidance system, a home security system, an industrial robotic system, or the like. Since the SoC 100 may be prone to manufacturing and operational defects, the SoC 100 may include on-chip testing circuitry which is used to detect such defects. For ease of testing, the SoC 100 is divided into multiple cores or partitions (e.g., first through fifth partitions 102, 104, 106, 107, 109) that are tested in various configurations, such as by using an Automatic Test Pattern Generator (ATPG) to run tests to achieve a desired test coverage and test-pattern count for the SoC 100. The partitions 102, 104, 106, 107, 109 may have identical or varying sizes without deviating from the scope of the disclosure.

As depicted, one or more inter-partition circuits 103, 105, 108 are connected between the partitions 102, 104, 106, 107, 109, where each inter-partition circuit refers to a node, electrical trace, buffer(s), and/or logic circuits that couple two consecutive partitions of the SoC 100. For example, the first and second partitions 102 and 104 are coupled with each other by way of the first inter-partition circuit 103. The second and third partitions 104 and 106 are coupled with each other by way of the second inter-partition circuit 105. The fourth and fifth partitions 107 and 109 are coupled with each other by way of the third inter-partition circuit 108. Of course, an individual downstream partition may be connected to receive data from more than one upstream partition. For example, the fifth partition 109 may also be connected to receive data from the first partition 102 by way of the third inter-partition circuit 108 and/or the first inter-partition circuit 103, as shown. The SoC 100 further includes a plurality of input pins 101 and a plurality of output pins 110 for external coupling. For the sake of brevity, the SoC 100 is shown with five partitions 102, 104, 106, 107, 109 and three inter-partition circuits 103, 105, 108, but it will be appreciated that the SoC 100 may include a different count of partitions, inter-partition circuits, and input/output pins and may have a different organization thereof.

With this configuration, the SoC 100 may be tested to detect defects in core logic of each of the first through fifth partitions 102, 104, 106, 107, 109, as well as defects in the interconnections (i.e., the first through third inter-partition circuits 103, 105, 108) between the partitions 102, 104, 106, 107, 109. To this end, individual partitions 102, 104, 106, 107, 109 of the SoC 100 may be tested in internal test (INTEST) mode and an external test (EXTEST) mode. In particular, the internal core logic of each partition-under-test may be tested by operating the partition in an INTEST mode. And in order to detect defects in inter-partition circuit or external logic between partitions, each preceding or upstream partition that is connected over an intervening inter-partition circuit to the partition-under-test may be operated in an external test (EXTEST) mode. During the EXTEST mode, the wrapper chains at the input boundary of a partition-under-test capture data from an inter-partition circuit coupled to the input boundary, and in addition, the wrapper chains at an output boundary of the preceding or upstream partition provide (or launch) data to an inter-partition circuit coupled to the output boundary. Further, existing test architectures use output pins 110 to observe the data stored in the wrapper chains at the output boundary and input pins 101 to control the data to be stored in the wrapper chains at the input boundary, during the EXTEST mode. However, since the SoC 100 has a limited number of input/output pins, only a limited number of partitions could be activated simultaneously in the EXTEST mode. As only a limited number of partitions could be activated simultaneously, a large number of test-combinations are required to achieve a desired testing coverage and test-pattern count, which in turn increases SoC test time requirements.

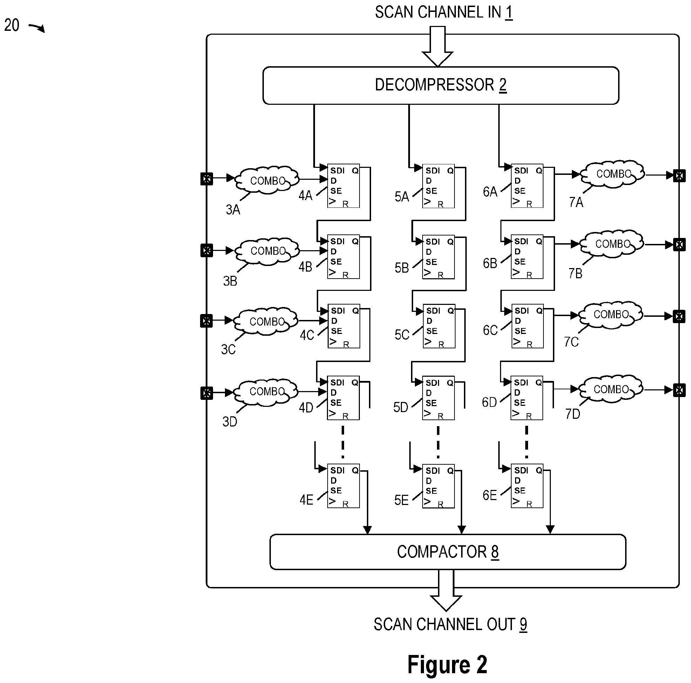

To provide a contextual understanding for selected embodiments of the present disclosure, reference is now made to Figure 2 which depicts a simplified schematic block diagram of an integrated circuit 20 with a first conventional scan chain testing design for testing SoC digital logic. For the sake of brevity, the integrated circuit 20 is depicted as including input combinational logic 3A-D (that is connected to receive input functional data from inputs on the left) and output combinational logic 7A-D (that is connected to output functional data from output on the right), though it is appreciated that additional logic may be included on the integrated circuit 20 between the input and output combinational logic blocks. In addition, the integrated circuit 20 includes a first set of input wrapper chains 4A-E at an input boundary of the integrated circuit 20, a second set of interior scan chains 5A-E, and a third set of output wrapper chains 6A-E at an output boundary of the integrated circuit 20. The first set of input wrapper chains 4A-E is separated from the third set of output wrapper chains 6A-E by the second set of interior scan chains 5A-E. Each input wrapper chain 4A-E includes a first plurality of wrapper cells and each output wrapper chain 6A-E includes a second plurality of wrapper cells. The first plurality of wrapper cells and the second plurality of wrapper cells are each, respectively, coupled in a series arrangement, and may be implemented using any suitable wrapper architecture or design, such as a plurality of series-connected D-type flip-flops. As known in the art, a D-type flip-flop (also known as "data" or "delay" flip-flop) is a circuit that has two stable states and can be used to store state information. In operation, a D-type flip-flop captures the value of the D-input at a definite portion of an input clock signal (indicated with the ">" input), and the captured value becomes the Q output. Each depicted D-type flip flop (e.g., 4A) may also include a reset R input which resets the flop to remember a reset value (e.g., "0" or LOW value) and a scan data input (SDI) input. With the SDI inputs of each flop connected to the decompressor or Q output of a preceding flop, the D-type flip-flops may be connected to form the first and second pluralities of wrapper cells (e.g., 4A-E, 6A-E).

In the depicted integrated circuit 20, the wrapper and scan chains 4A-E, 5A-E, 6A-E are connected in parallel between a decompressor circuit 2 and a compactor or compressor circuit 8. With an input coupled to a scan channel input 1 and with a plurality of outputs connected, respectively, to the wrapper and scan chains 4A-E, 5A-E, 6A-E, the third decompressor circuit 2 is configured to implement a decompression logic to decompress data that is received at the scan channel input 1. In addition, the compactor circuit 8 is coupled between outputs from the wrapper and scan chains 4A-E, 5A-E, 6A-E and a scan channel output 9, and may be configured to implement a compression logic to compress data that is received from the wrapper and scan chains 4A-E, 5A-E, 6A-E.

In cases where the integrated circuit 20 is implementing a relatively small SoC system, it is relatively straightforward to generate ATPG test patterns that provide coverage for the whole SoC system from the chip top. And with smaller SoC designs, there are no concerns about obtaining test coverage of inter-partition circuitry or external logic between partitions when the integrated circuit 20 is not partitioned. However, as SoCs become larger in size, it is increasingly difficult to generate full coverage scan patterns from the chip top level due to huge power consumption during scan and resulting test shift frequency constraints. As a result, SoC designs are split into multiple partitions so that the scan operations can be targeted to a smaller logic footprint, thereby reducing device power consumption. However, multi-partition SoC designs present a new set of challenges with providing comprehensive scan mode tests. For example, there are challenges with getting scan test coverage of the "inter-partition" circuits located between partitions for both stuck-at and at-speed faults.

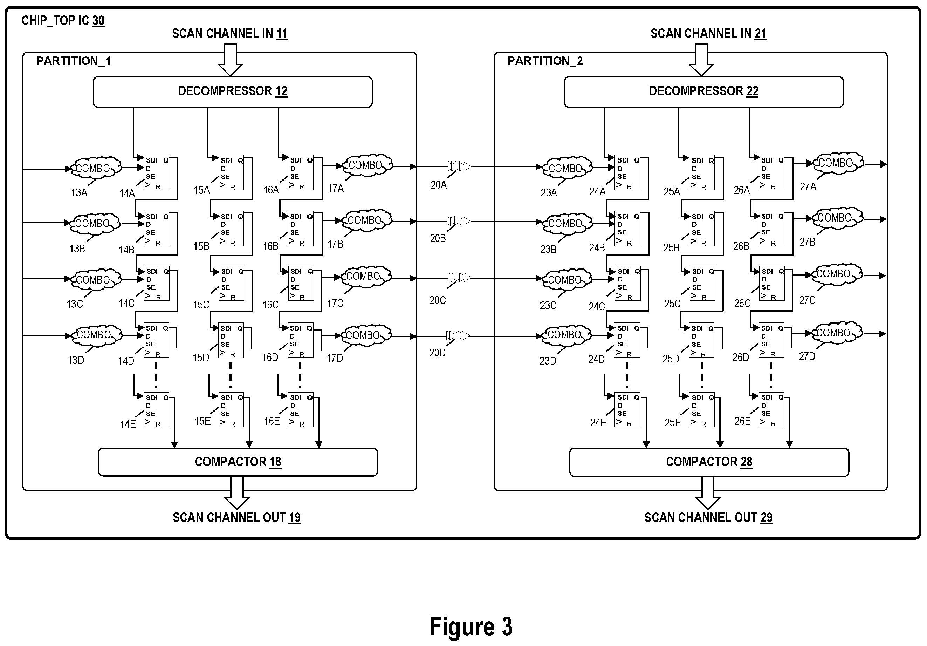

To provide additional details for an improved understanding of the challenges presented with multi-partition SoC systems, reference is now made to Figure 3 which depicts a simplified schematic block diagram of a chip top integrated circuit 30 which employs a conventional partitioned scan chain testing design for testing SoC digital logic. As depicted, the chip top IC 30 includes a first partition (Partition_1) and a second partition (Partition _2) coupled to one another over a plurality of inter-partition circuit elements 20A-20D. While each of the inter-partition circuit elements 20A-20D is depicted as a sequence of buffers, it will be appreciated that the inter-partition circuit elements 20A-20D may include any suitable combinational logic elements, including but not limited to standard library cells, such as multiplexers, AND gates, OR gates, NAND gates, etc. As depicted, each inter-partition circuit element (e.g., 20A) connects a functional data path of combinatorial logic (e.g., 13A, 17A) at the first partition with a functional data path of combinatorial logic (e.g., 23A, 27A) at the second partition. As will be appreciated, each of the partitions (Partition_1, Partition _2) are identical in relevant respect to the design of the integrated circuit 20 shown in Figure 2. Thus, the first partition (Partition_1) includes a scan channel input 11, a decompressor 12 (which decompresses and distributes the received scan channel input), input wrapper chains 14A-E, interior scan chains 15A-E, output wrapper chains 16A-E, and a compactor circuit 18 which compresses data that is received from the wrapper and scan chains 14A-E, 15A-E, 16A-E for output to the scan channel output 19. In similar fashion, the second partition (Partition_2) includes a scan channel input 21, a decompressor 22 (which decompresses and distributes the received scan channel input), input wrapper chains 24A-E, interior scan chains 25A-E, output wrapper chains 26A-E, and a compactor circuit 28 which compresses data that is received from the wrapper and scan chains 24A-E, 25A-E, 26A-E for output to the scan channel output 29.

With the depicted arrangement of wrapper and scan chains 14-16, 24-26 in the multi-partition chip top IC 30, it can be readily seen that when the scan is run on individual partition, there is no scan test coverage provided for the inter-partition circuit elements 17A-17D, 20A-20D, 23A-23D, 20A-20D that connect the first and second partitions (Partition_1, Partition _2). Previous approaches for addressing this scan test coverage deficiency have been proposed, but each suffers from one or more deficiencies in terms of test logic overhead, netlist insertion overhead, failure to provide test coverage at functional frequency, timing degradation of the functional data paths, etc.

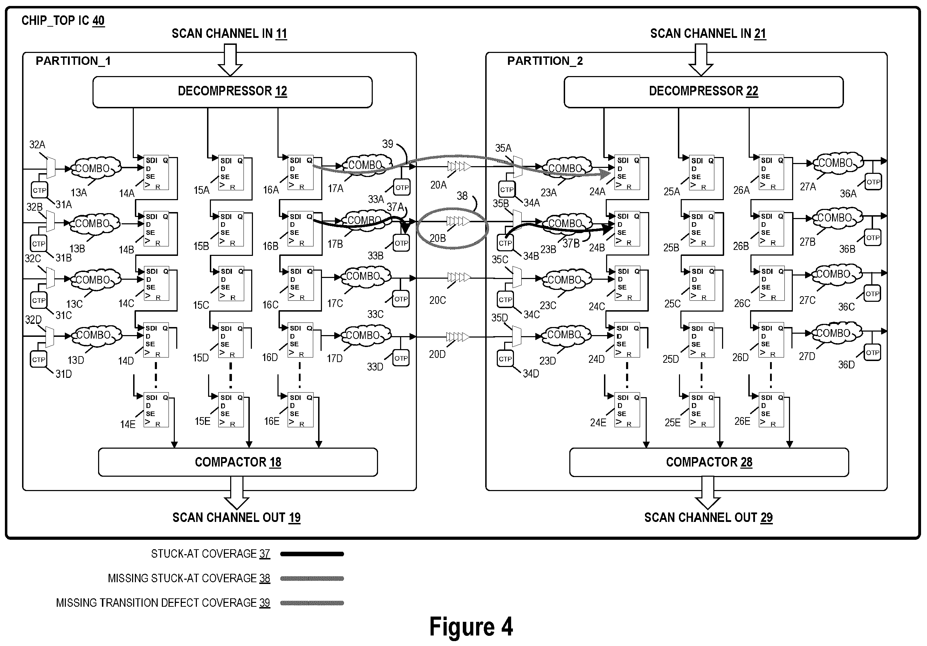

To illustrate a first example of a legacy solution for providing scan test coverage of multi-partition SoC systems, reference is now made to Figure 4 which depicts a simplified schematic block diagram of chip top integrated circuit 40 which employs a partitioned scan chain testing design which includes controllable and observable test points 31-36 at the front and back end of the functional data paths in each partition. As depicted, the chip top IC 40 includes a first partition (Partition_1), a plurality of inter-partition circuit elements 20A-20D, and a second partition (Partition _2) which are connected and configured identically in relevant respect to the design of the chip top IC 30 shown in Figure 3. However, the chip top IC 40 also includes controllable and observable test point logic at each partition which provides additional test coverage for combinatorial logic blocks 13, 17, 23, 27 in each partition. In particular, the first partition (Partition_1) includes controllable test points (CTP) 31A-31D, such as flip-flops, that are respectively connected at the input to the combinatorial logic blocks 13A-13D via a corresponding input multiplexer circuit 32A-32D. In addition, the first partition includes an observable test point (OTP) 33A-33D, such as a flip-flop, that is connected at each output from the combinatorial logic blocks 17A-17D. In similar fashion, the second partition (e.g., Partition_2) includes controllable test points (CTP) 34A-34D connected via corresponding input multiplexer circuits 35A-35D at the input to the input combinatorial logic blocks 23A-23D, as well as observable test points (OTP) 36A-36D connected at the output from the output combinatorial logic blocks 27A-27D. Though not expressly shown, the CTP flops 31A-31D, 33A-34D are each connected as a scan chain, and the OTP flops 33A-33D, 36A-36D are also each connected as a scan chain. In addition, they may be part of the same scan chain or different scan chains. As indicated with the covered test paths 37A, 37B, the additional test point circuitry 31-36 enables scan testing for structural stuck-AT coverage of the input and output combinatorial logic blocks (e.g., 13, 17) at each partition. However, there are a number of scan test deficiencies not covered by the additional test point circuitry 31-36. For example, the insertion of the input multiplexer circuits 32A-32D, 35A-D into the functional data path will degrade the functional timing, thereby preventing or impairing the ability to truly perform testing of the functional part at speed testing. In addition and as indicated by the missing stuck-AT coverage 38, the additional test point circuitry 31-36 does not provide structural stuck-at and at-speed coverage for the inter-partition circuit elements 20A-20D. The additional test point circuitry 31-36 also does not provide transition defect (TD) coverage (a.k.a., "at speed" tests) for the functional data path (e.g., 16A, 17A, 20A, 35A, 24A) operating at the functional device specification (e.g., operational frequency), as indicated by the missing transition defect coverage 39. Thus, the additional test point circuitry 31-36 does not provide full scan test coverage for the inter-partition circuit elements 20A-20D. Finally, it should be noted that the additional test point circuitry 31-36 requires additional test logic overhead by virtue of including the test point flops and multiplex input circuitry.

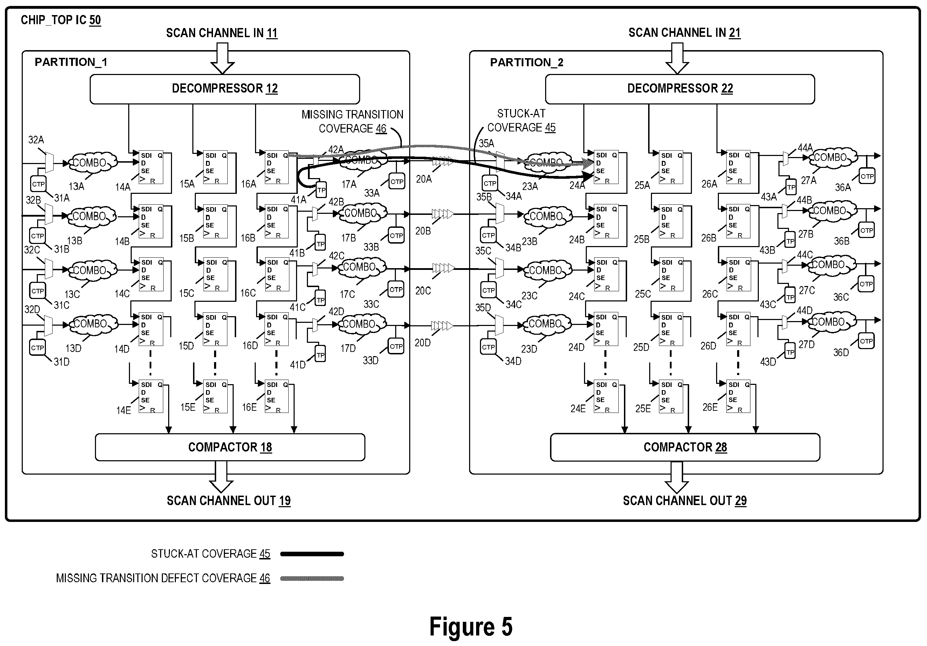

To illustrate another example of a legacy solution for providing scan test coverage of multi-partition SoC systems, reference is now made to Figure 5 which depicts a simplified schematic block diagram of chip top integrated circuit 50 which employs a partitioned scan chain testing design which includes controllable and observable test points 31-36 and wrapper flops 41, 43 at the front and back end of the functional data paths in each partition. As depicted, the chip top IC 50 includes a first partition (Partition_1), a plurality of inter-partition circuit elements 20A-20D, and a second partition (Partition _2) which are connected and configured identically in relevant respect to the design of the chip top IC 40 shown in Figure 4. However, the chip top IC 50 also includes controllable test point logic at each partition which provides partial test coverage for the inter-partition circuit elements 20A-20D connected between the partitions. In particular, the first partition (Partition_1) includes controllable test points (TP) 41A-41D, such as flip-flops, that are respectively connected at the input to the output combinatorial logic blocks 17A-17D via a corresponding input multiplexer circuit 42A-42D. In addition, the second partition (e.g., Partition_2) includes controllable test points (TP) 43A-43D connected at the input to the output combinatorial logic blocks 27A-27D via a corresponding input multiplexer circuit 44A-44D. Again, the TP flops 41A-41D, 43A-43D are each connected as a scan chain in the same or different scan chains. As indicated with the covered test path 45, the additional test point circuitry 31-36, 41-44 enables scan testing for structural stuck-AT coverage of the input and output combinatorial logic blocks (e.g., 13, 17) at each partition as well as the inter-partition circuit elements 20A-20D. However, there remain scan test deficiencies not covered by the additional test point circuitry 31-36, 41-44. In addition to the degraded functional timing caused by inserting the input multiplexer circuits 32A-32D, 42A-42D, 35A-D, 44A-44D into the functional data path, the additional test point circuitry 31-36, 41-44 does not provide transition defect (TD) coverage for the functional data path (e.g., 16A, 17A, 20A, 35A, 24A) operating at the functional device specification (e.g., operational frequency), as indicated by the missing transition defect coverage 46. This results from the fact that the scan test launches the test value from the test point (e.g., 41A) and not from the actual functional flip-flop 16A. Thus, the additional test point circuitry 31-36, 41-44 does not provide full scan test coverage for the inter-partition circuit elements 20A-20D. Finally, it should be noted that the additional test point circuitry 31-36, 41-44 requires additional test logic overhead by virtue of including the test point and wrapper flops and multiplex input circuitry.

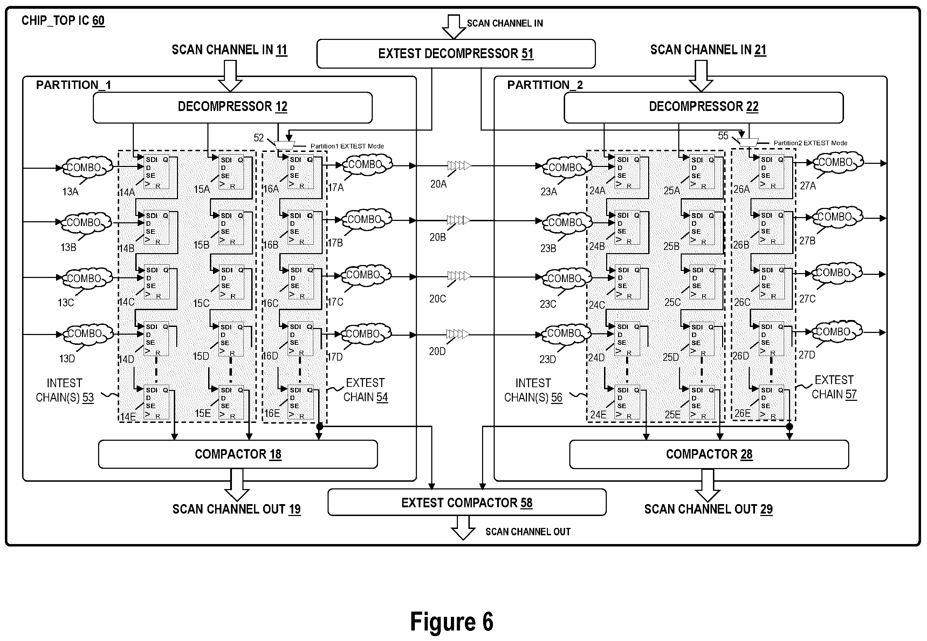

To illustrate yet another example of a legacy solution for providing scan test coverage of multi-partition SoC systems, reference is now made to Figure 6 which depicts a simplified schematic block diagram of chip top integrated circuit 60 which employs a partitioned scan chain testing design using INTEST and EXTEST chains that are separately controlled with external EXTEST decompressors and compactors for testing SoC digital logic. As depicted, the chip top IC 60 includes a first partition (Partition_1), a plurality of inter-partition circuit elements 20A-20D, and a second partition (Partition _2) which are connected and configured identically in relevant respect to the design of the chip top IC 30 shown in Figure 3. However, the input wrapper chains composed of scan flip flops 14A-E and interior scan chains composed of scan flip flops 15A-E in the first partition (Partition_1) are arranged and controlled as a first set of input test (INTEST) chains 53 at an input boundary of the first partition. In addition, the output wrapper chains 16A-E in the first partition (Partition_1) are arranged and controlled as a first set of output or external test (EXTEST) chains 54 at an output boundary of the first partition. As depicted, the EXTEST chain 54 includes the last flops 16A-E which provide partition outputs through the output combinatorial logic blocks 17A-E. Though not shown, the first partition may also include a first set of interior scan chains arranged between the INTEST chain(s) 53 and EXTEST chain 54. In similar fashion, the second partition (Partition _2) includes a second set of input test (INTEST) chains 56 at an input boundary of the second partition (which includes the input wrapper chains 24A-E and interior scan chains 25A-E) and a second set of output or external test (EXTEST) chains 57 which may include the output wrapper chains 26A-E at an output boundary of the second partition.

In addition to the decompressors 12, 22 and compactors 18, 28 provided at the first and second partitions, the chip top IC 60 also includes an external EXTEST decompressor 51 and EXTEST compactor 58 which are connected to separately control the EXTEST chain 54, 57 without the decompressors 12, 22 and compactors 18, 28 being activated or powered. To this end, each partition also includes multiplexer/selection circuits 52, 55 coupled select between the partition decompressor 12, 22 and the external EXTEST decompressor 51 as inputs, and to output to the corresponding EXTEST chain 54, 57 in response to a partition EXTEST mode signal. As shown, the external EXTEST decompressor 51 is coupled to receive data from a second set of scan channel inputs, to implement a decompression logic to decompress the received data, and to output a decompressed set of output signals to the multiplexer/selection circuits 52, 55 which are respectively controlled by the partition EXTEST mode signals, "Partition 1 EXTEST Mode" and "Partition 2 EXTEST Mode." In this way, each EXTEST chain 54, 57 may be selectively coupled to the second set of scan channel inputs by way of the external EXTEST decompressor 51 and the multiplexer/selection circuits 52, 55. In addition, the EXTEST compactors 18, 28 are each coupled to the EXTEST chains 54, 57 at a corresponding output, and are configured to implement a compression logic to compress data that is received from the EXTEST chains 54, 57. As seen from the foregoing, when performing a scan test of the second partition (Partition _2), the decompressor 12 and compactor 18 in the first partition (Partition_1) can be deactivated or disabled so that the INTEST chains 53 are deactivated, but the external EXTEST decompressor 51 can be enabled to activate the EXTEST chain 54 in the first partition (Partition_1) for use in generating scan test inputs for the second partition (Partition _2). While the chip top IC 60 provides good scan test coverage for the partitions and inter-partition circuit elements 20A-20D, there are performance and design drawbacks from using the external EXTEST decompressor 51 and EXTEST compactor 58 to control the EXTEST chains 54, 57. For example, there is test logic overhead required by adding the EXTEST decompressor 51 and EXTEST compactor 58 to the chip top IC 60. In addition, there is timing closure overhead using STA (static timing analysis) tool resulting from the timing shift path from EXTEST decompressor and compactor. In addition, the shift path to be timed at-speed as Scan enable of EXTEST chains 54, 57 is always high. Another drawback is the netlist integration overhead of connecting EXTEST EDTs with the partition EXTEST chains 54, 57. There is also a netlist overhead for replicating clock gating cells (CGs) to gate the clock to the INTEST scan chains 53, 56 while ensuring that the EXTEST chains 54, 57 are clocked. In addition, there is a timing overhead caused by adding additional clock gating on the functional clock path. It should also be noted that the EXTEST chains 54, 57 in such conventional solutions typically require that the loading or shifting of SDI data at shift mode must be done at functional frequency when the common scan enable signal is applied. Finally, it should be noted that the external EXTEST decompressor 51, external compactor 58, and the multiplexer/selection circuits 52, 55 requires decompressor and compactor structures, and also requires additional netlist insertion overhead to connect the external EXTEST decompressor 51 and external compactor 58 to the EXTEST chains 54, 57.

To address these shortcomings from conventional solutions and others known to those skilled in the art, there is disclosed herein a scan wrapper architecture which provides an efficient mechanism for performing scan tests of partitions and inter-partition circuits on a multi-partition SoC chip by configuring each partition with separately controllable INTEST and EXTEST scan chains. To this end, each partition includes digital test control access hardware for each INTEST scan chain which may be selectively disabled while allowing the EXTEST scan chain to continue operating. In selected embodiments, the digital test control access hardware circuitry may be embodied with scan data input gating circuitry (e.g., with an "AND" gate) for logically combining an inverted partition EXTEST mode signal with a first decompressed scan data input signal that is input to said INTEST scan chain. As a result, the digital test control access hardware operates to load a constant scan data input value to each INTEST scan chain during EXTEST scanning mode, thereby saving power that would otherwise be used to shift different scan data input values into each INTEST scan chain. In addition, each partition may include a launch-off-shift scan enable circuit for generating separately controllable scan enable signals for the INTEST scan chain(s) (SE_INT) and EXTEST scan chain(s) (SE_EXT) in response to the partition EXTEST mode signal. With the disclosed scan wrapper approach of providing a scan data input AND gating circuit at each INTEST scan chain, comprehensive and efficient scan testing of multi-partition SoC systems is provided which avoids the shortcomings from conventional solutions.

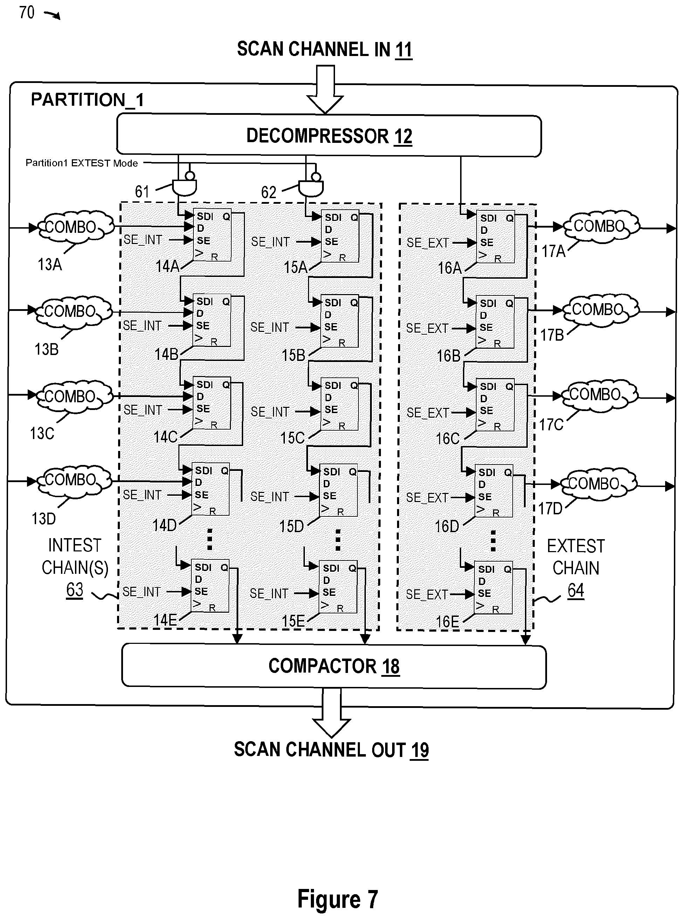

To illustrate selected embodiments of the disclosed scan wrapper architecture, reference is now made to Figure 7 which is a simplified schematic block diagram of a single integrated circuit partition (Partition_1) 70 with a scan chain testing design using INTEST and EXTEST chains 63, 64 that are separately controllable with internal logical AND gating circuits 61, 62 and separate launch off shift scan enable signals SE_INT, SE_EXT for testing SoC digital logic in accordance with selected embodiments of the present disclosure. As depicted, the IC partition 70 includes circuit elements 11-19 that are connected and configured identically in relevant respect to the design of the circuit elements for the first partition (Partition_1) shown in Figure 3. However, the input wrapper chains 14A-E and interior scan chains 15A-E in the IC partition 70 are arranged and controlled as a first set of input test (INTEST) chains 63 at an input boundary of the IC partition 70. In addition, the output wrapper chains 16A-E in the IC partition 70 are arranged and controlled as a first set of output or external test (EXTEST) chains 64 at an output boundary of the IC partition 70. As depicted, the EXTEST chain 64 includes the last flops 16A-E which provide partition outputs through the output combinatorial logic blocks 17A-E. As will be appreciated, the IC partition 70 may also include a first set of interior scan chains (not shown) that are arranged between the INTEST chain(s) 63 and EXTEST chain 64.

While the INTEST chain(s) 63 and EXTEST chain 64 are shown as being coupled between the decompressor 12 and compactor 18, the IC partition 70 also includes digital test control access hardware 61, 62 connected between the decompressor 12 and INTEST chain(s) 63. Thus connected, the digital test control access hardware 61, 62 selectively gates the INTEST chain(s) 63 so that the decompressor 12 effectively loads a constant value into the INTEST chain(s) 63, thereby saving shift power. While any suitable gating circuit may be used for the digital test control access hardware 61, 62, selected embodiments of the present disclosure may implement the digital test control access hardware circuitry with an AND gate 61, 62 connected between the decompressor 12 and each INTEST chain 63, where each AND gate 62 is connected to logically combine an inverted partition EXTEST mode signal with the decompressed scan data input signal that is input to each INTEST scan chain 14, 15. As depicted, the AND gates 61, 62 for the input wrapper chains 14A-E and interior scan chains 15A-E may each be implemented with an inverted input to receive the partition EXTEST mode signal. Alternatively, a separate inverter circuit may be provided to receive and invert the partition EXTEST mode signal for output to the AND gates 61, 62. In yet other embodiments, the AND gates 61, 62 may be merged with the corresponding input D-type flip-flop 14A, 15A as a single cell in the library.

By using the inverted partition EXTEST mode signal at each AND gate 61, 62 to gate the INTEST chain(s) 63, no values are shifted into the INTEST chain(s) when the decompressor 12 is powered ON, and as a result, there is no power consumed by the INTEST scan chain(s) from shifting constant values. However, the EXTEST chain 64 is able to shift values from the decompressor 12 without requiring the timing and logic overhead of including external EXTEST decompressor, compactor 51, and multiplexer/selection circuits, such as depicted in Figure 6.

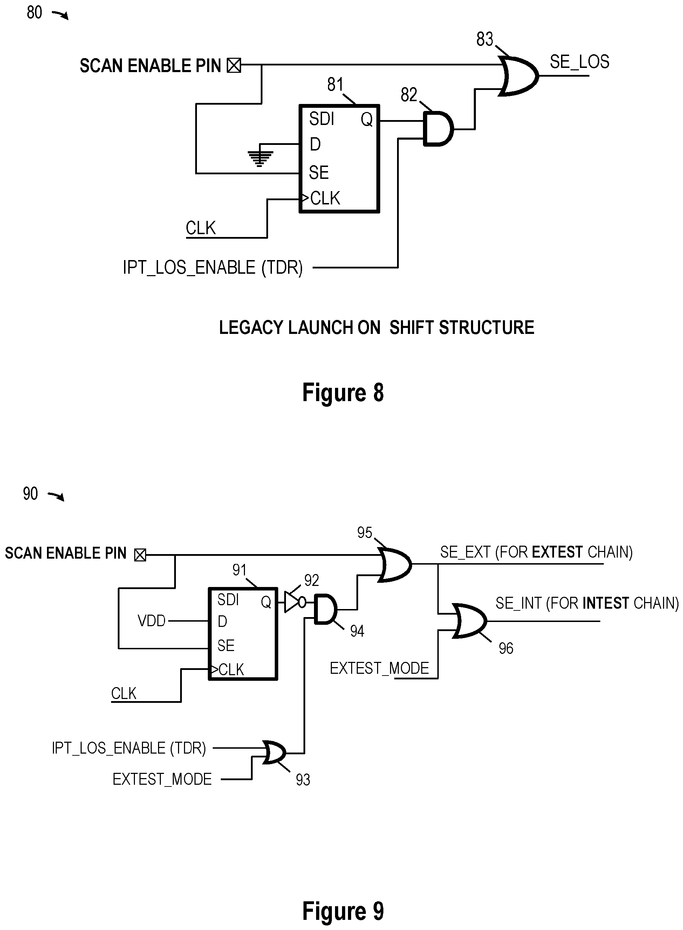

With conventional partition designs (such as shown in Figure 3), all flops (e.g., 14-16) in a partition (e.g., Partition_1) would be controlled with a common scan enable SE signal. To provide an example of a circuit for generating a common scan enable SE signal, reference is now made to Figure 8 which depicts a schematic circuit diagram of a conventional launch-off-shift (LOS) scan enable (SE) signal generator 80. As depicted, the LOS SE signal generator 80 includes a D-type flip-flop 81, AND gate 82, and OR gate 83 connected to generate the LOS SE signal (SE_LOS) in response to the scan enable pin (denoting the shift or capture phase) and IPT_LOS _ENABLE signal stored in a test data register (TDR). In particular, the D-type flip-flop 81 has a data input D connected to ground, and is clocked by a clock input signal CLK to generate a data output signal Q. The LOS SE signal generator 80 also includes an AND gate 82 connected to logically combine the data output Q from the D-type flip-flop 81 with an IPT_LOS enable signal (TDR). The resulting output from the AND gate 82 is logically combined at an OR gate 83 with the scan enable pin value to generate the LOS SE signal (SE_LOS). As a result of the common SE_LOS signal, all the Flip Flops in the partition moves from Shift to capture and might contribute to more power consumption which cannot be supported by the device during test mode.

As disclosed herein, there are performance advantages for obtaining scan test coverage when the scan enable signals provided to the INTEST and EXTEST scan chains are separately controlled. In particular and as shown in Figure 7, the IC partition 70 includes an EXTEST chain 64 with a scan enable signal SE_EXT that is separate from the scan enable signal SE_INT for the INTEST chain(s) 63. In particular, each flop 14A-E, 15A-E in the INTEST scan chain(s) 63 is connected to receive an INTEST scan enable signal SE_INT, whereas each flop 16A-E in the EXTEST scan chain 64 is connected to receive an EXTEST scan enable signal SE_EXT that is generated separately from the INTEST scan enable signal SE_INT. With this approach, the INTEST chain(s) 63 for a partition under test will always remain in shift mode when the INTEST scan enable signal SE_INT is "HIGH," but when applying an EXTEST mode to a supplying or upstream partition, the INTEST scan enable signal SE_INT for the INTEST chains(s) 63 is "HIGH".

While any suitable circuit may be used for generating separate scan enable signals SE_INT, SE_EXT, reference is now made to Figure 9 which depicts a schematic circuit diagram of a launch-off-shift (LOS) scan enable (SE) signal generator 90 for generating separate LOS scan enable signals for the INTEST and EXTEST chains. As depicted, the LOS SE signal generator 90 includes a D-type flip-flop 91, inverter 92, input OR gate 93, AND gate 94, first output OR gate 95 connected to generate the LOS SE signal for the EXTEST chain (SE_EXT), and second output OR gate 96 connected to generate the LOS SE signal for the INTEST chain (SE_INT) in response to the scan enable pin (denoting the shift or capture phase), the IPT_LOS_ENABLE signal stored in a test data register (TDR), and the partition EXTEST mode signal (EXTEST_MODE) is also stored as part of the test data register. In selected embodiments, the D-type flip-flop 91 may be included as part of the INTEST scan chain to receive the scan chain enable pin as the top level SE input pin.

As depicted, the D-type flip-flop 91 has a data input D connected to a supply voltage (e.g., V_{DD}), and is clocked by a clock input signal CLK to generate a data output signal Q. The LOS SE signal generator 90 also includes an inverter 92 which inverts the data output Q from the D-type flip-flop 91. In addition, the LOS SE signal generator 90 includes the input OR gate 93 which logically combines the IPT_LOS enable signal (TDR) with the partition EXTEST mode signal (EXTEST_MODE). At the AND gate 94, the outputs from the inverter 92 and input OR gate 93 are logically combined to generate an input for the first output OR gate 95 where it is logically combined with the scan enable pin value to generate the LOS SE signal for the EXTEST chain (SE_EXT). And at the second output OR gate 96, the LOS SE signal for the EXTEST chain (SE_EXT) and the partition EXTEST mode signal (EXTEST_MODE) are logically combined to generate the LOS SE signal for the INTEST chain (SE_INT). As a result of generating separate scan enable signals SE_INT, SE_EXT, the flops in the INTEST chain(s) can have separately controlled scan enable signals from the flops in the EXTEST chain, resulting in more power savings during scan testing when INTEST scan chains are loaded with constant data.

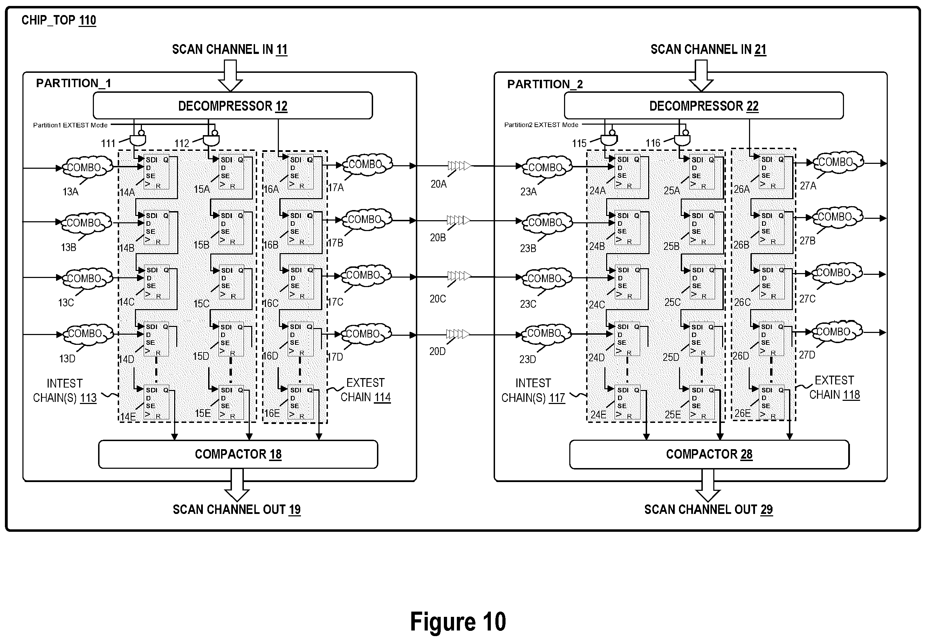

For an improved understanding of selected embodiments of the present disclosure, reference is now made to Figure 10 which depicts a simplified schematic block diagram of a chip top integrated circuit 110 which employs a partitioned scan chain testing design using INTEST chains 113, 117 and EXTEST chains 114, 118 that are separately controllable with internal logical AND gating circuits 111-112, 115-116 and separate launch off shift scan enable signals for testing SoC digital logic. As depicted, the chip top IC 110 includes a first partition (Partition_1), a plurality of inter-partition circuit elements 20A-20D, and a second partition (Partition _2) which are connected and configured identically in relevant respect to the design of the chip top IC 30 shown in Figure 3. In selected embodiments, the input wrapper chains 14A-E and interior scan chains 15A-E in the first partition (Partition_1) are arranged and controlled as a first set of input test (INTEST) chains 113 at an input boundary of the first partition. However, in other embodiments, there are no separate input wrapper chains when the INTEST scan chain is intermingled together with input wrapper chains and interior chains. In addition, the output wrapper chains 16A-E in the first partition (Partition_1) are arranged and controlled as a first set of output or external test (EXTEST) chains 114 at an output boundary of the first partition. In similar fashion, the second partition (Partition _2) includes a second set of input test (INTEST) chains 117 at an input boundary of the second partition (which includes the input wrapper chains 24A-E and interior scan chains 25A-E) and a second set of output or external test (EXTEST) chains 118 which may include the output wrapper chains 26A-E at an output boundary of the second partition.

While each partition (Partition_1, Partition _2) includes INTEST chains 113, 117 and EXTEST chains 114, 118 that are coupled as shown between the decompressors 12, 22 and compactors 18, 28, the IC partition 110 also includes digital test control access hardware 111-112, 115-116 connected between the decompressors 12, 22 and the INTEST chains 113, 117 to selectively gate the INTEST chains 113, 117 so that each decompressors 12, 22 can effectively load a constant value into the INTEST chains 113, 117 in response to a corresponding partition EXTEST mode signal (Partition_1 EXTEST MODE, Partition2 EXTEST MODE). In selected embodiments, the digital test control access hardware circuitry is implemented with logical AND gates 111-112, 115-116 that are connected between a decompressor 12, 22 and INTEST chain 113, 117, where each AND gate 111-112, 115-116 is connected to logically combine an inverted partition EXTEST mode signal with the decompressed scan data input signal that is input to each INTEST scan chain 14, 15, 24, 25.

In operation when a partition (e.g., Partition _2) is the partition under test, then the corresponding partition EXTEST mode signal (Partition_2 EXTEST MODE) is set to LOW or "0" and the scan enable signals SE_INT, SE_EXT for the INTEST and EXTEST chains 117, 118 are HIGH or "1" during the shift mode of scan testing. Upon inversion of the partition EXTEST mode signal (Partition2 EXTEST MODE) at the inverted input to the digital test control access hardware 115-116, the AND gates 115, 116 become transparent and the decompressor 22 is enabled to provide scan data input to the INTEST and EXTEST chains 117, 118 where they are shifted in response to the scan enable signals SE_INT, SE_EXT.

However, when a partition (e.g., Partition_1) is in EXTEST mode, then the corresponding partition EXTEST mode signal (Partition_1 EXTEST MODE) is set to HIGH or "1," and the scan enable signals SE_INT, SE_EXT are generated for the INTEST and EXTEST chains 113, 114. As a result of generating separate scan enable signals SE_INT, SE_EXT for the partition in EXTEST mode, the SDI data can be shifted into the EXTEST scan chain at a first, lower frequency that is below the functional frequency used during capture mode of scan testing. During EXTEST mode testing of a partition, the scan enable signals SE_INT, SE_EXT for that partition are set by the launch-off-shift (LOS) scan enable (SE) signal generator, such as shown in Figure 9. As a result, the scan enable for the INTEST chain always remains high through the shift and capture phase to ensure that all flip flops in the INTEST chain remain under shift mode throughout, thereby saving power. However, the scan enable of the EXTEST Chain may toggle so that the flip flops within the EXTEST chain can launch/capture the test data. Upon inversion of the partition EXTEST mode signal (Partition1 EXTEST MODE) at the inverted input to the digital test control access hardware 111-112, the digital test control access hardware 111, 112 effectively loads a constant value (e.g., "0") for input to the INTEST chain(s) 113, and the decompressor 12 is only able to shift data values into the EXTEST chain 114. This EXTEST mode testing of an upstream partition (e.g., Partition_1) allows scan testing of the inter-partition circuit elements 20A-20D which provide inputs to the downstream partition under test (e.g., Partition _2).

While the foregoing example depicted in Figure 10 is provided to illustrate how an upstream partition (e.g., Partition_1) may be placed in EXTEST mode scan testing to enable the control of inputs from the inter-partition circuit elements 20A-20D to the downstream partition under test (e.g., Partition _2), it will be appreciated that other partition relationships may occur. For example, the second partition (e.g., Partition_2) may be connected over inter-partition circuit elements (not shown) to the first partition (Partition_1), in which case the first partition (Partition _1) is the downstream partition under test and the second partition (e.g., Partition _2) is the upstream partition which is placed in EXTEST mode. Also, there may be multiple upstream partitions connected over inter-partition circuit elements to a downstream partition, in which case each upstream partition may be placed in EXTEST mode using corresponding partition EXTEST mode signals and scan enable signals SE_INT, SE_EXT. If there are N partitions in the design, then the EXTEST Mode of all the partition(s) under scan test should be "0" and EXTEST Mode for all the other remaining partitions should be value 1.

As will be appreciated, there are numerous advantages provided by the scan wrapper design for testing a multi-partition SoC chip by configuring each partition with separately controllable INTEST and EXTEST scan chains. For example, by configuring each partition with embedded scan data input AND gating circuitry to connect each decompressor to the INTEST scan chains in response to a partition EXTEST mode signal, this eliminates the need for additional test logic overhead, such as test point or wrapper flops or extra decompressor and compactor blocks. In addition, there are timing benefits from using the embedded scan data input AND gating circuitry since it does not add circuits to the functional data path. And by embedding the scan data input AND gating circuitry to the individual partition designs, this eliminates the need for additional netlist insertion overhead outside of the partition design, such as would be required by adding external decompressor/compactor circuitry. The disclosed technique for separately generating INTEST and EXTEST scan enable signals also allows scan data input to be shifted into the scan chains at a frequency that is below the functional frequency used during capture mode of scan testing.

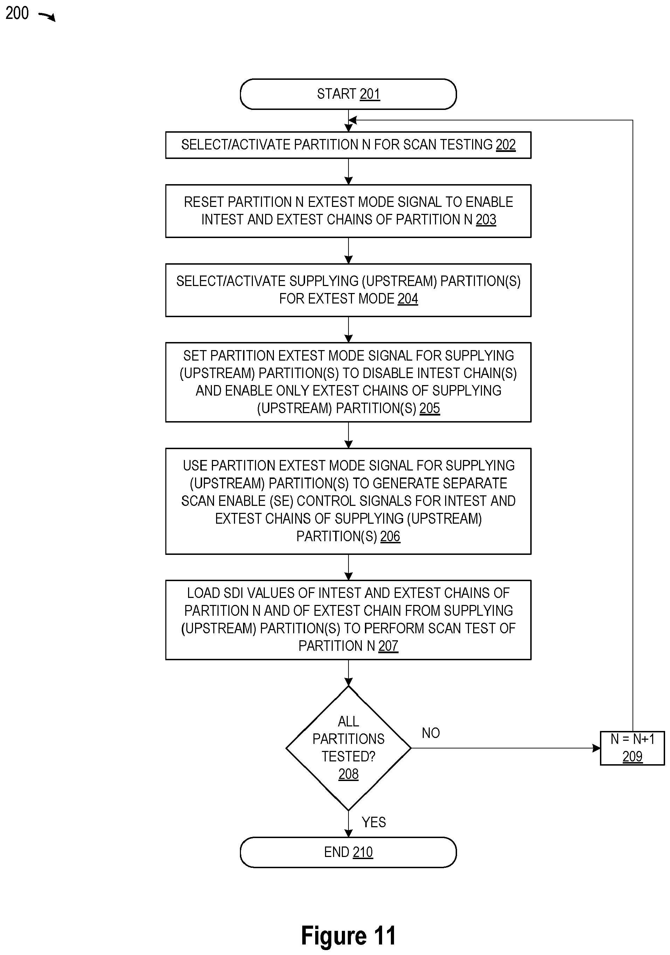

To provide additional details for an improved understanding of selected embodiments of the present disclosure, reference is now made to Figure 11 which depicts a simplified flow chart 200 showing the logic for efficiently enabling scan testing of at least a portion of a multi-partition SoC. For the sake of brevity, the flow chart 200 is described with reference to the chip top IC 110 having the scan wrapper architecture of Figure 10.

After beginning at step 201, an initial step in the overall process occurs when a first partition (Partition N) is selected and/or activated for scan testing at step 202. With reference to the chip top IC 110, step 202 could be performed by selecting the second partition (Partition _2) as Partition N.

At step 203, the EXTEST signal mode signal for Partition N is reset to a first value (e.g., "0") to enable the INTEST and EXTEST chains in Partition N. With reference to the chip top IC 110, step 203 could be performed by resetting the Partition_2 EXTEST Mode signal that is provided to the inverted inputs of the logical AND gates 115-116.

At step 204, one or more supplying or upstream partitions are selected and/or activated for performing an EXTEST mode scan test. As used herein, a supplying or "upstream" partition is a preceding partition in the SoC data flow that supplies signals over inter-partition circuit elements to the selected Partition N. With reference to the chip top IC 110, step 204 could be performed by selecting the first partition (Partition_1) as the supplying or upstream partition.

At step 205, the EXTEST signal mode signal(s) for the supplying or upstream partition(s) are set to a second value (e.g., "1") to disable the INTEST chain(s) and to enable only the EXTEST chains in the supplying or upstream partition(s). With reference to the chip top IC 110, step 205 could be performed by setting the Partition_1 EXTEST Mode signal at the supplying/upstream partition (Partition_1) so that, when provided to the inverted inputs of the logical AND gates 111-112, the INTEST scan chains 14A-E, 15A-E are effectively disabled and only the EXTEST scan chain 16A-E is enabled to receive scan data input from the decompressor 12.

At step 206, the EXTEST signal mode signal(s) for the supplying or upstream partition(s) are used to generate separate scan enable (SE) control signals SE_INT, SE_EXT for the INTEST and EXTEST chains of the supplying or upstream partition(s). With reference to the chip top IC 110, step 206 could be performed by supplying the Partition1 EXTEST Mode signal for the supplying/upstream partition (Partition_1) to a launch-off-shift (LOS) scan enable (SE) signal generator (such as shown in Figure 9) to generate the scan enable signals SE_INT, SE_EXT for the supplying/upstream partition (Partition_1). At the same time, scan enable (SE) control signals can be generated for Partition N so that the INTEST and EXTEST chains of Partition N are all enabled.

At step 207, scan data input (SDI) values are loaded or shifted by the decompressor of the Partition N into the INTEST and EXTEST chains of Partition N under control of the SE control signals generated for Partition N. In addition, SDI values are loaded or shifted by the decompressor of the supplying/upstream partition(s) into the EXTEST chain(s) of the supplying/upstream partition(s) under control of the SE control signals SE_INT, SE_EXT for the supplying/upstream partition(s). With reference to the chip top IC 110, step 207 could be performed by loading SDI values into the scan chains 24-26 for the INTEST and EXTEST chains 117, 118 at Partition_2 while simultaneously loading SDI values only into the scan chain 16 for the EXTEST chain 114 at Partition_1. Once SDI values are shifted into the EXTEST scan chain of the supplying/upstream partition(s) and the INTEST and EXTEST chains of Partition N under test, the scan test enters the capture mode of operation during which launch and capture clock pulses are applied to test the inter-partition circuit elements (between the upstream partition(s) and to the Partition N under test) as well as the Partition N under test.

At step 208, the methodology determines if all of the partitions in the multi-partition SoC have been tested. If not (negative outcome to detection step 208), then another partition is identified by incrementing the "N"' counter (step 209) and then returning to Step 202 where the next "Partition N" is selected and activated. However, if there are no more partitions to test, then the process ends at step 210.

An apparatus (110) and method (200) are provided for scan testing a system-on-chip (SoC) integrated circuit having first and second partitions coupled together across one or more inter-partition circuits, each of which includes a decompressor; a compactor; an INTEST scan chain and an EXTEST scan chain coupled in parallel between the decompressor circuit and compactor circuit; and digital test control access hardware connected between the decompressor circuit and each INTEST scan chain and configured to selectively disable each INTEST scan chain while each EXTEST scan chain continues to operate in response to a partition EXTEST mode signal having a first predetermined value.

Some of the above embodiments, as applicable, may be implemented using a variety of different data processing systems. For example, although Figure 10 and the discussion thereof describe an exemplary multi-partition microcontroller SoC device in which a test access control circuit is employed, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architecture depicted herein is merely exemplary, and that in fact many other architectures can be implemented which achieve the same functionality. In an abstract, but still definite sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermediate components. Likewise, any two components so associated can also be viewed as being "operably connected," or "operably coupled," to each other to achieve the desired functionality. Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

By now it should be appreciated that there has been provided an architecture, apparatus, method, program code, and system for scan testing a system-on-chip (SoC) integrated circuit having first and second partitions coupled together across one or more inter-partition circuits. In the disclosed SoC integrated circuit, each the first and second partitions includes a decompressor circuit, a compactor circuit, an INTEST scan chain and an EXTEST scan chain coupled in parallel between the decompressor circuit and compactor circuit, and digital test control access hardware connected between the decompressor circuit and each INTEST scan chain and configured to selectively disable each INTEST scan chain while each EXTEST scan chain continues to operate in response to a partition EXTEST mode signal having a first predetermined value. In selected embodiments, each of the INTEST scan chain and an EXTEST scan chain include a first plurality of wrapper cells coupled in a series arrangement such that scan data input is serially shifted into the first plurality of wrapper cells. In selected embodiments, the digital test control access hardware includes an AND gate connected between the decompressor circuit and each INTEST scan chain, where each AND gate includes a first input connected to receive scan data input from the decompressor circuit, a second inverted input connected to receive the partition EXTEST mode signal, and an output connected to the INTEST scan chain. In other selected embodiments, the digital test control access hardware in each partition is connected between the decompressor circuit and each INTEST scan chain and is configured to enable each INTEST scan chain to operate while each EXTEST scan chain continues to operate in response to the partition EXTEST mode signal having a second predetermined value. In other embodiments, the EXTEST scan chain in the first partition includes a first set of output wrapper chains connected directly between the decompressor circuit and compactor circuit of the first partition. In addition, the INTEST scan chain in the second partition may include a first set of input wrapper chains connected directly between the digital test control access hardware and compactor circuit of the first partition. In addition, the first set of output wrapper chains in the first partition may be connected over the one or more inter-partition circuits to the first set of input wrapper chains in the second partition. In selected embodiments, each partition of the SoC integrated circuit also includes a launch-off-shift (LOS) scan enable (SE) signal generator connected and configured to generate separate LOS SE signals for the INTEST scan chain and EXTEST scan chain in response to the partition EXTEST mode signal having the first predetermined value when a scan enable pin value is set. In operation of the SoC integrated, the first partition is configured to shift input test data into the EXTEST scan chain of the first partition during a scan shift mode of operation. In addition, the one or more inter-partition circuits are configured to receive the input test data from a first set of output wrapper chains in the EXTEST scan chain of the first partition and to generate test response data based on the input test data. In addition, a first set of input wrapper chains in the INTEST scan chain of the second partition is configured to receive the test response data and provide the test response data to be captured as first output test data to test the one or more inter-partition circuits.

In another form, there has been provided an architecture, apparatus, program code, system and method for scan testing a system-on-chip (SoC) comprising first and second partitions coupled together across an inter-partition circuit. In the disclosed method, the first partition is operated in an external test (EXTEST) mode while the second partition is simultaneously operated in an internal test (INTEST) mode to capture output test data sent by the first partition over the inter-partition circuit to the second partition. In particular, the first partition is operated in the EXTEST mode by receiving first input test data at a first set of input channels coupled to the first partition; selectively disabling one or more first INTEST chains of the first partition in response to a first partition EXTEST mode signal while selectively storing first intermediate data in a first EXTEST chain of the first partition, wherein the first intermediate data is generated based on the first input test data and shifted into the first EXTEST chain under control of a first scan enable signal; and providing the first intermediate data to the inter-partition circuit by the first EXTEST chain of the first partition. In selected embodiments, the first intermediate data is selectively stored in the first EXTEST chain of the first partition by serially shifting the first intermediate data into a first plurality of wrapper cells included in the first EXTEST chain. As disclosed, the inter-partition circuit generates the test response data in response to receiving the first intermediate data. In selected embodiments, the step for selectively disabling one or more first INTEST chains of the first partition may include supplying the first partition EXTEST mode signal to a digital test control access circuit connected between a decompressor circuit and the one or more first INTEST chains in the first partition, where the digital test control access circuit is configured to selectively disable the one or more first INTEST chains while each EXTEST chain continues to operate in response to the first partition EXTEST mode signal having a first predetermined value. In such embodiments, the disclosed method may also include decompressing the first input test data at the first partition using the decompressor circuit to generate the first intermediate data before storing the first intermediate data in the first EXTEST chain of the first partition. In addition, the second partition is simultaneously operated in the INTEST mode by receiving second input test data at a second set of input channels coupled to the second partition; selectively enabling one or more second INTEST chains of the second partition in response to a second partition EXTEST mode signal to store second intermediate data in the one or more second INTEST chains and a second EXTEST chain of the second partition, wherein the second intermediate data is generated based on the second input test data and shifted into the one or more second INTEST chains and the second EXTEST chain under control of a second scan enable signal; receiving test response data by the one or more second INTEST chains of the second partition from the inter-partition circuit, wherein the test response data is generated based on the first intermediate data; and capturing first output test data at a first set of output channels coupled to the one or more second INTEST chains of the second partition, wherein the first output test data is generated based on the test response data. In selected embodiments, the first output test data may be captured at the first set of output channels by serially shifting the test response data out of a second plurality of wrapper cells included in the one or more second INTEST chains. In other embodiments, the disclosed method may also include testing the inter-partition circuit by comparing the first output test data with first predefined data. In still other embodiments, the disclosed method may also include generating, for the first partition, separate launch-off-shift (LOS) scan enable (SE) signals, respectively, for the one or more first INTEST chains and for the first EXTEST chain in response to the first partition EXTEST mode signal having the first predetermined value when a scan enable pin value is set.

In yet another form, there has been provided a system-on-chip (SoC) architecture, apparatus, program code, and method of operation. As disclosed, the SoC includes first set of input channels, a first partition, a first set of output channels, a second partition, and an inter-partition circuit. The disclosed first partition includes one or more first INTEST chains and a first EXTEST chain coupled to the first set of input channels, and also includes a first digital test control access circuit coupled between the first set of input channels and the one or more first INTEST chains and configured to selectively disable the one or more first INTEST chains while the first EXTEST chain continues to operate in response to a first partition EXTEST mode signal having a first predetermined value. In selected embodiments, the first digital test control access circuit in the first partition is further configured to enable the one or more first INTEST chains and the first EXTEST chain to operate in response to the first partition EXTEST mode signal having a third predetermined value that is different from the first predetermined value. In other selected embodiments, the first digital test control access circuit includes an AND gate connected between a decompressor circuit and each of the one or more first INTEST chains, where each AND gate includes a first input connected to receive scan data input from the decompressor circuit, and a second inverted input connected to receive the first partition EXTEST mode signal. The disclosed second partition includes one or more second INTEST chains and a second EXTEST chain coupled to the first set of output channels, and also includes a second digital test control access circuit coupled between the first set of input channels and the one or more second INTEST chains and configured to selectively disable the one or more second INTEST chains while the second EXTEST chain continues to operate in response to a second partition EXTEST mode signal having a second predetermined value. In selected embodiments, the second digital test control access circuit in the second partition is further configured to enable the one or more second INTEST chains and the second EXTEST chain to operate in response to the second partition EXTEST mode signal having a fourth predetermined value that is different from the second predetermined value. The disclosed inter-partition circuit is coupled between the first EXTEST chain of the first partition and the one or more second INTEST chains of the second partition. During an external test (EXTEST) mode of the SoC, the first set of input channels is configured to receive first input test data. And during the EXTEST mode, the first EXTEST chain is configured to receive and store first intermediate data while the one or more first INTEST chains are selectively disabled in response to a first partition EXTEST mode signal, wherein the first intermediate data is generated based on the first input test data and shifted into the first EXTEST chain under control of a first scan enable signal. And during the EXTEST mode, the inter-partition circuit is configured to receive the first intermediate data from the first EXTEST chain and to generate test response data based on the first intermediate data. And during the EXTEST mode, the one or more second INTEST chains and a second EXTEST chain are configured to receive the test response data, and provide the test response data to be captured as first output test data at the first set of output channels to test the inter-partition circuit. In selected embodiments, the disclosed SoC may also include a launch-off-shift (LOS) scan enable (SE) signal generator connected and configured to generate separate LOS SE signals for the one or more first INTEST chains and the first EXTEST chain in response to the first partition EXTEST mode signal having the first predetermined value when a scan enable pin value is set

Various illustrative embodiments of the present invention have been described in detail with reference to the accompanying figures. While various details are set forth in the foregoing description, it will be appreciated that the present invention may be practiced without these specific details, and that numerous implementation-specific decisions may be made to the invention described herein to achieve the circuit designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are shown in block diagram form, rather than in detail, in order to avoid limiting or obscuring the present invention. In addition, some portions of the detailed descriptions provided herein are presented in terms of algorithms or operations on data within a computer memory. Such descriptions and representations are used by those skilled in the art to describe and convey the substance of their work to others skilled in the art. Although the described exemplary embodiments disclosed herein are directed to an exemplary multi-partition scan wrapper solution, the present invention is not necessarily limited to the example embodiments illustrate herein, and various embodiments of the circuitry and methods disclosed herein may be implemented with other devices and software components. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the spirit and scope of the invention as defined by the appended claims so that those skilled in the art should understand that they can make various changes, substitutions and alterations without departing from the spirit and scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A system-on-chip (SoC) integrated circuit comprising first and second partitions coupled together across one or more inter-partition circuits, each of the first and second partitions comprising:
a decompressor circuit;
a compactor circuit;
an INTEST scan chain and an EXTEST scan chain coupled in parallel between the decompressor circuit and compactor circuit; and
digital test control access hardware connected between the decompressor circuit and each INTEST scan chain and configured to selectively disable each INTEST scan chain while each EXTEST scan chain continues to operate in response to a partition EXTEST mode signal having a first predetermined value.

2. The SoC integrated circuit of claim 1, where the digital test control access hardware connected between the decompressor circuit and each INTEST scan chain is configured to enable each INTEST scan chain to operate while each EXTEST scan chain continues to operate in response to the partition EXTEST mode signal having a second predetermined value.

3. The SoC integrated circuit of any preceding claim, where the digital test control access hardware comprises an AND gate connected between the decompressor circuit and each INTEST scan chain, where each AND gate comprises:
a first input connected to receive scan data input from the decompressor circuit, and
a second inverted input connected to receive the partition EXTEST mode signal.

4. The SoC integrated circuit of any preceding claim,
where the EXTEST scan chain in the first partition comprises a first set of output wrapper chains connected directly between the decompressor circuit and compactor circuit of the first partition;
where the INTEST scan chain in the second partition comprises a first set of input wrapper chains connected directly between the digital test control access hardware and compactor circuit of the first partition; and
where the first set of output wrapper chains in the first partition is connected over the one or more inter-partition circuits to the first set of input wrapper chains in the second partition.

5. The SoC integrated circuit of any preceding claim, further comprising, for each of the first and second partitions, a launch-off-shift (LOS) scan enable (SE) signal generator connected and configured to generate separate LOS SE signals for the INTEST scan chain and EXTEST scan chain in response to the partition EXTEST mode signal having the first predetermined value when a scan enable pin value is set.

6. The SoC integrated circuit of any preceding claim, wherein the first partition is configured to shift input test data into the EXTEST scan chain of the first partition during a scan mode of operation; wherein the one or more inter-partition circuits are configured to receive the input test data from a first set of output wrapper chains in the EXTEST scan chain of the first partition and to generate test response data based on the input test data; and wherein a first set of input wrapper chains in the INTEST scan chain of the second partition is configured to receive the test response data and provide the test response data to be captured as first output test data to test the one or more inter-partition circuits.

7. The SoC integrated circuit of any preceding claim, wherein each of the INTEST scan chain and an EXTEST scan chain include a first plurality of wrapper cells coupled in a series arrangement such that scan data input is serially shifted into the first plurality of wrapper cells.

8. A method for testing a system-on-chip (SoC) comprising first and second partitions coupled together across an inter-partition circuit, the method comprising:
operating the first partition in an external test (EXTEST) mode while simultaneously operating the second partition in an internal test (INTEST) mode to capture output test data
sent by the first partition over the inter-partition circuit to the second partition;
wherein operating the first partition in the EXTEST mode comprises:
receiving first input test data at a first set of input channels coupled to the first partition,
selectively disabling one or more first INTEST chains of the first partition in response to a first partition EXTEST mode signal while selectively storing first intermediate data in a first EXTEST chain of the first partition, wherein the first intermediate data is generated based on the first input test data and shifted into the first EXTEST chain under control of a first scan enable signal, and
providing the first intermediate data to the inter-partition circuit by the first EXTEST chain
of the first partition; and
wherein operating the second partition in the INTEST mode comprises:
receiving second input test data at a second set of input channels coupled to the second partition,
selectively enabling one or more second INTEST chains of the second partition in response to a second partition EXTEST mode signal to store second intermediate data in the one or more second INTEST chains and a second EXTEST chain of the second partition, wherein
the second intermediate data is generated based on the second input test data and shifted into the one or more second INTEST chains and the second EXTEST chain under control of a second scan enable signal,
receiving test response data by the one or more second INTEST chains of the second partition from the inter-partition circuit, wherein the test response data is generated based on the first intermediate data, and
capturing first output test data at a first set of output channels coupled to the one or more second INTEST chains of the second partition, wherein the first output test data is generated based on the test response data.

9. The method of claim 8, wherein selectively disabling one or more first INTEST chains of the first partition comprises supplying the first partition EXTEST mode signal to a digital test control access circuit connected between a decompressor circuit and the one or more first INTEST chains in the first partition, where the digital test control access circuit is configured to selectively disable the one or more first INTEST chains while each EXTEST chain continues to operate in response to the first partition EXTEST mode signal having a first predetermined value.

10. The method of claim 9, further comprising decompressing the first input test data at the first partition using the decompressor circuit to generate the first intermediate data before storing the first intermediate data in the first EXTEST chain of the first partition.

11. The method of any of claims 8 to 10, where the inter-partition circuit generates the test response data in response to receiving the first intermediate data.

12. The method of any of claims 8 to 11, wherein selectively storing first intermediate data in the first EXTEST chain of the first partition comprises serially shifting the first intermediate data into a first plurality of wrapper cells included in the first EXTEST chain.

13. The method of any of claims 8 to 12, wherein capturing the first output test data at the first set of output channels comprises serially shifting the test response data out of a second plurality of wrapper cells included in the one or more second INTEST chains.

14. The method of any of claims 8 to 13, further comprising testing the inter-partition circuit by comparing the first output test data with first predefined data.

15. The method of any of claims 8 to 14, further comprising generating, for the first partition, separate launch-off-shift (LOS) scan enable (SE) signals, respectively, for the one or more first INTEST chains and for the first EXTEST chain in response to the first partition EXTEST mode signal having the first predetermined value when a scan enable pin value is set.
